# EUROPÄISCHE PATENTSCHRIFT

(11) **EP 0 886 995 B1**
(45) Veröffentlichungstag und Bekanntmachung des Hinweises auf die Patenterteilung: **28.07.1999**
(21) Anmeldenummer: 97905016.8
(22) Anmeldetag: 13.02.1997
(51) Int. Cl.: H05K 7/20, H02B 1/56

(54) **KÜHLGERÄT ZUM ANBAU AN DIE RÜCKWAND, SEITENWAND ODER TÜR EINES SCHALTSCHRANKES**
COOLER FOR FITTING TO THE REAR OR SIDE WALL OR THE DOOR OF A SWITCHING CABINET
APPAREIL REFRIGERANT DESTINE A ETRE MONTE SUR LA PAROI ARRIERE, LA PAROI LATERALE OU LA PORTE D'UNE ARMOIRE DE COMMANDE

(30) Priorität: 13.03.1996 DE 19609845
(43) Veröffentlichungstag der Anmeldung: 30.12.1998
(73) Patentinhaber: Rittal-Werk Rudolf Loh GmbH & Co. KG, 35745 Herborn (DE)
(72) Erfinder: DIEBEL, Michael, D-35687 Dillenburg (DE); EDELMANN, Achim, D-35686 Dillenburg (DE); NICOLAI, Walter, D-35418 Buseck (DE); STRACKBEIN, Heinrich, D-35444 Biebertal (DE)
(74) Vertreter: Fleck, Hermann-Josef, Dr.-Ing.
(86) Internationale Anmeldenummer: EP9700657
(87) Internationale Veröffentlichungsnummer: WO9734454

(56) Entgegenhaltungen:
- DE-U- 6 916 926
- DE-U- 29 519 260
- FR-A- 2 410 936
- US-A- 4 609 126

## Beschreibung

Die Erfindung betrifft ein Kühlgerät, das anstelle einer Rückwand, Seitenwand oder Tür eines Schaltschrankes anbaubar ist und über eine Eintrittsöffnung und eine Austrittsöffnung eines Innenkreislaufes mit diesem in Verbindung bringbar ist.

Derartige Kühlgeräte sind in der Regel nur als Wärmetauscher ausgelegt. Dabei bereitet die Trennung von Innenkreislauf und Außenkreislauf stets Schwierigkeiten. Ist diese Trennung nicht vollkommen, dann ist nicht immer eindeutig vermeidbar, daß Feuchtigkeit in den Schaltschrank gelangt. Diese Schwierigkeiten nehmen erheblich zu, wenn der Schaltschrank mit dem Kühlgerät im Freien aufgestellt wird, da dann der Schutz gegen Regen und Schmutzteilchen hinzu kommt.

Ein witterungsgeschützter Elektronik-Schaltschrank für die Aufstellung im Freien ist z. B. aus DE-U-29519260 bekannt.

Es ist Aufgabe der Erfindung, bei einem Kühlgerät der eingangs erwähnten Art den Schutz des Wärmetauschers gegen Kondenswasser, Regen und Schmutzteile wesentlich zu verbessern.

Diese Aufgabe wird nach der Erfindung dadurch gelöst, daß das Kühlgerätegehäuse neben einem mittleren, oben offenen Entlüftungsschacht seitlich davon vertikale, oben offene Lüftungskammern eines hermetisch vom Innenkreislauf getrennten Außenkreislaufs aufweist, daß die Oberseite von Schaltschrank und Kühlgerätegehäuse im Abstand von denselben mittels eines Dachelementes abgedeckt ist, das allseitig den Schaltschrank und das Kühlgerätegehäuse überragt und ringsum einen nach unten offenen Lüftungsschlitz freiläßt, und daß das Dachelement mittels Trennbleche in Kammern unterteilt ist, die mit dem Entlüftungsschacht und den beiden Lüftungskammern des Kühlgerätegehäuses in Verbindung stehen. Darüberhinaus bietet das Dachelement ausreichend Schutz gegen Regen und Schmutzteile und ist mit den abgeteilten Kammern in die Belüftung mit einbezogen.

Der Regenschutz läßt sich nach einer weiteren Ausgestaltung dadurch noch verbessern, daß das Dachelement mit einem umlaufenden, nach unten abgewinkelten Rand versehen ist, der sich teilweise in den Bereich der Seitenwände von Schaltschrank und Kühlgerätegehäuse erstreckt. Das Abtropfen des Regenwassers wird dadurch erleichtert, daß das Dachelement eine horizontal ausgerichtete Deckplatte aufweist, die über geneigte, abfallende Übergangsabschnitte in den Rand übergeht und daß die Ecken des Dachelementes im Bereich des Randes und der Übergangsabschnitte abgeschrägt sind.

Eine an die Querschnittsform des Schaltschrankes angepaßte Ausgestaltung ist dadurch gekennzeichnet, daß bei einem im Querschnitt rechteckförmigen Schaltschrank die Trennwände des Dachelementes symmetrisch und parallel zur vertikalen, von der Vorder- zur Rückseite des Schaltschrankes verlaufenden Mittelebene des Schaltschrankes ausgerichtet sind und sich von der Rückseite des Kühlgerätegehäuses bis zur Vorderseite des Schaltschrankes erstrecken.

Die Bildung eines rings umlaufenden Lüftungsschlitzes wird nach einer Ausgestaltung dadurch erreicht, daß das Dachelement über Abstandselemente mit der Oberseite von Schaltschrank und/oder Kühlgerätegehäuse verbunden ist.

Eine vollständige Entkopplung der Kammern des Dachelementes wird dadurch erreicht, daß die Trennbleche an den Innenquerschnitt des Dachelementes angepaßt sind und sich auf der Oberseite von Schaltschrank und Kühlgerätegehäuse abstützen.

Die Erfindung wird anhand eines in den Zeichnungen dargestellten Ausführungsbeispiels näher erläutert. Es zeigen:
- Fig. 1: 1 in schematischer Perspektive einen Schaltschrank mit als Kühlgerät ausgebildeter Rückwand und aufgesetztem Dachelement, und
- Fig. 2: eine schematische Draufsicht auf das Dachelement mit den Kammern und den Lüftungswegen.

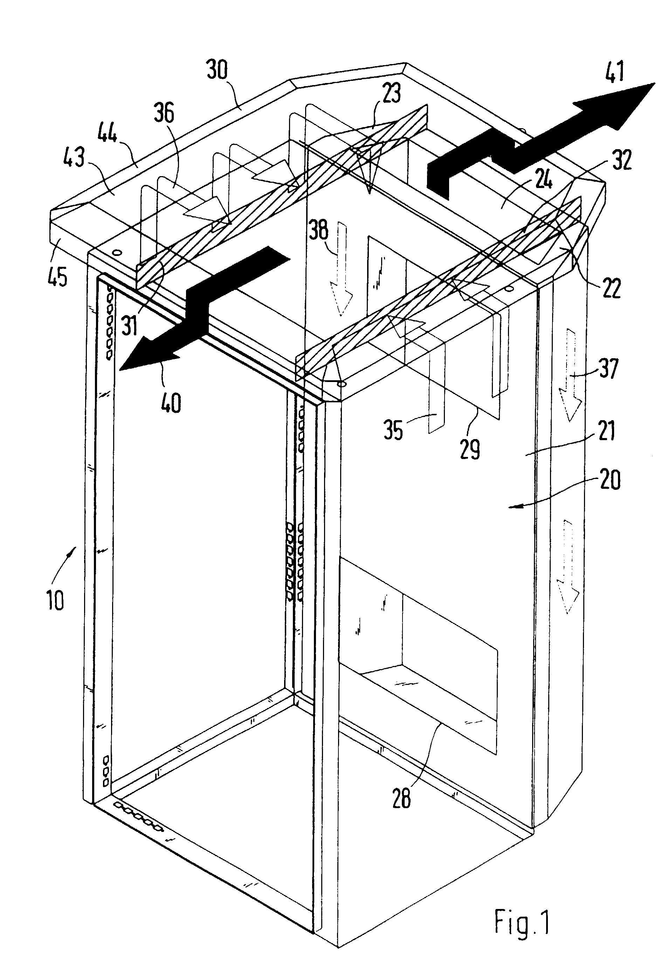

In der Fig. 1 ist von dem Schaltschrank 10 nur das Rahmengestell angedeutet. Die Rückseite des Rahmengestelles ist mit einem Kühlgerät verschlossen, von dem in der Zeichnung nur das Kühlgerätegehäuse 20 gezeigt ist, da der Aufbau des Kühlgerätes für die vorliegende Erfindung nicht von Bedeutung ist. Das im Querschnitt trapezförmige Kühlgerät schließt mit der Wand 21 die Rückseite des Rahmengestelles allseitig bündig ab. Das Kühlgerät kann auch eine Seitenwand des Schaltschrankes 10 ersetzen oder selbst als Türe ausgebildet sein. Das Kühlgerät steht über eine Eintrittsöffnung 28 und eine Austrittsöffnung 28 mit dem Schaltschrank-Innenraum in Verbindung. Das Kühlgerätegehäuse 20 ist in einen mittleren Entlüftungsschacht 24 und seitlich davon in die beiden Lüftungskammern 22 und 23 unterteilt. Der dem Außenkreislauf zugeordnete Entlüftungsschacht 24 ist hermetisch von den Lüftungskammern 22 und 23 getrennt. Der Entlüftungsschacht 24 und die Lüftungskammern 22 und 23 sind oben offen.

Auf der Oberseite von Schaltschrank 10 und Kühlgerätegehäuse 20 ist über Abstandselemente ein Dachelement 30 befestigt. Dieses Dachelement 30 besteht aus einer horizontalen Deckplatte 43, die über geneigte, abfallende Übergangsabschnitte 43 in einen nach unten abgewinkelten Rand 45 übergeht. Das Dachelement 30 ragt an allen Seiten über den Schaltschrank 10 und das Kühlgerätegehäuse 20 vor und bildet ringsum einen nach unten offenen Lüftungsschlitz.

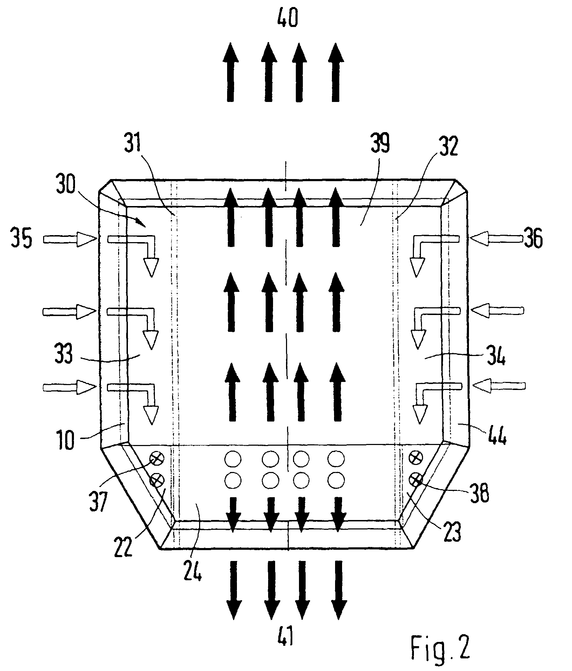

Wie die Draufsicht nach Fig. 2 zeigt, ist der Innenraum des Dachelementes 30 mit den beiden Trennwänden 31 und 32 in drei Kammern 33, 34 und 39 unterteilt. Im Ausführungsbeispiel erstrecken sich die Trennwände 31 und 32 von der Vorderseite des Schaltschrankes 10 zur Rückseite des Kühlgerätegehäuses 20 und sind so angeordnet, daß die Kammer 33 mit der Lüftungskammer 22, die Kammer 34 mit der Lüftungskammer 23 und die Kammer 39 mit dem Entlüftungsschacht 24 in Verbindung stehen. Die aus dem Entlüftungsschacht 24 ausströmende Luft kann über die Kammer 39 des Dachelementes 30 an der Vorderseite des Schaltschrankes 10 und die Rückseite des Kühlgerätegehäuses 20 über den Lüftungsschlitz austreten, wie die Pfeile 40 und 41 andeuten.

Zu beiden Seiten des Schaltschrankes 10 wird Frischluft angesaugt, wie die Pfeile 35 und 36 zeigen. Diese Frischluft gelangt über den Lüftungsschlitz in die Kammern 33 und 34 und darüber in die Lüftungskammern 22 und 23 des Kühlgerätes, wie die Pfeile 37 und 38 zeigen.

Die Trennwände 31 und 32 verlaufen parallel zueinander und stehen symmetrisch zur vertikalen Mittelebene des Schaltschrankes 10, die von der Vorder- zur Rückseite steht, wie der Fig. 2 zu entnehmen ist. Der Rand 45 des Dachelementes 30 erstreckt sich teilweise in den Bereich der Seitenwände von Schaltschrank 10 und Kühlgerätegehäuse 20, so daß der Regen- und Staubschutz verbessert ist.

Die Querschnittsform des Schaltschrankes und des Kühlgerätes kann auch anders gestaltet sein. Die Unterteilung des Dachelementes 30 mittels der Trennwände 31 und 32 in die Kammern 33, 34 und 39 muß stets so sein, daß sie voneinander getrennt mit den Lüftungskammern 22 und 23 und dem Entlüftungsschacht 24 in Verbindung stehen.

Der Entlüftungsschacht 24 kann je nach Anwendung auch als Ansaugschacht verwendet werden und die Strömungsrichtung in den Lüftungskammern 22 und 23 kann auch von unten nach oben gerichtet sein. Dies hängt wiederum von dem oder den Kreisläufen im Schaltschrank ab.

## Patentansprüche

1. Kühlgerät, das anstelle einer Rückwand, Seitenwand oder Tür eines Schaltschrankes anbaubar ist und über eine Eintrittsöffnung und eine Austrittsöffnung eines Innenkreislaufes mit diesem in Verbindung bringbar ist,
dadurch gekennzeichnet,
daß das Kühlgerätegehäuse (20) neben einem mittleren, oben offenen Entlüftungsschacht (24) seitlich davon vertikale, oben offene Lüftungskammern (22,23) eines hermetisch vom Innenkreislauf getrennten Außenkreislaufs aufweist,
daß die Oberseite von Schaltschrank (10) und Kühlgerätegehäuse (20) im Abstand von denselben mittels eines Dachelementes (30) abgedeckt ist, das allseitig den Schaltschrank (10) und das Kühlgerätegehäuse (20) überragt und ringsum einen nach unten offenen Lüftungsschlitz freiläßt, und
daß das Dachelement (30) mittels Trennblechen (31,32) in Kammern (33,34, 39) unterteilt ist, die mit dem Entlüftungsschacht (24) und den beiden Lüftungskammern (22,23) des Kühlgerätegehäuses (20) in Verbindung stehen.

2. Kühlgerät nach Anspruch 1,
dadurch gekennzeichnet,
daß das Dachelement (30) mit einem umlaufenden, nach unten abgewinkelten Rand (45) versehen ist, der sich teilweise in den Bereich der Seitenwände von Schaltschrank (10) und Kühlgerätegehäuse (20) erstreckt.

3. Kühlgerät nach Anspruch 1 oder 2,
dadurch gekennzeichnet,
daß bei einem im Querschnitt rechteckförmigen Schaltschrank (10) die Trennwände (31,32) des Dachelementes (30) symmetrisch und parallel zur vertikalen, von der Vorder- zur Rückseite des Schaltschrankes (10) verlaufenden Mittelebene des Schaltschrankes (10) ausgerichtet sind und sich von der Rückseite des Kühlgerätegehäuses (20) bis zur Vorderseite des Schaltschrankes (10) erstrecken.

4. Kühlgerät nach einem der Ansprüche 1 bis 3,
dadurch gekennzeichnet,
daß das Dachelement (30) über Abstandselemente mit der Oberseite von Schaltschrank (10) und/oder Kühlgerätegehäuse (20) verbunden ist.

5. Kühlgerät nach einem der Ansprüche 1 bis 4,
dadurch gekennzeichnet,
daß das Dachelement (30) eine horizontal ausgerichtete Deckplatte (43) aufweist, die über geneigte, abfallende Übergangsabschnitte (44) in den Rand (45) übergeht.

6. Kühlgerät nach Anspruch 5,
dadurch gekennzeichnet,
daß die Ecken des Dachelementes (30) im Bereich des Randes (45) und der Übergangsabschnitte (44) abgeschrägt sind.

7. Kühlgerät nach einem der Ansprüche 1 bis 6,
dadurch gekennzeichnet,
daß die Trennbleche (31,32) an den Innenquerschnitt des Dachelementes (30) angepaßt sind und sich auf der Oberseite von Schaltschrank (10) und Kühlgerätegehäuse (20) abstützen.

8. Kühlgerät nach einem der Ansprüche 1 bis 7,
dadurch gekennzeichnet,
daß der Entlüftungsschacht (24) und die Lüftungskammern (22 und 23) in einer gemeinsamen Strömungsrichtung zur Be- oder Entlüftung des Schaltschrankes (10) verwendet sind.

9. Kühlgerät nach einem der Ansprüche 1 bis 7,
dadurch gekennzeichnet,
daß nur der Entlüftungsschacht (24) oder die Lüftungskammern (22,23) zur Beoder Entlüftung des Schaltschrankes (10) verwendet sind.

## Claims

1. Cooling appliance which may be attached instead of a rear wall, side wall or door of a switchgear cabinet and may be made to communicate with the latter via an entry aperture and an exit aperture of an inner circuit,
**characterised in that**
the cooling appliance housing (2) has, as well as a central upwardly open vent shaft (24) and at the side of same, upwardly open ventilating chambers (22,23) of an outer circuit hermetically separated from the inner circuit,
in that the upper side of switchgear (10) and cooling appliance housing (2) is covered, at a spacing from same, by means of a roof member (3) which protrudes on all sides above the switchgear cabinet (10) and the cooling appliance housing (20) and leaves free all round a downwardly open ventilating slot, and
in that the roof member (30) is subdivided by means of separating plates (31,32) into chambers (33,34, 39) which communicate with the vent shaft (24) and the two ventilating chambers (22,23) of the cooling appliance housing (20).

2. Cooling appliance according to claim 1,
**characterised in that**
the roof member (30) is provided with a downwardly angled peripheral edge (45) which extends partially into the region of the side walls of switchgear cabinet (10) and cooling appliance housing (20).

3. Cooling appliance according to claim 1 or 2,
**characterised in that**
on a switchgear cabinet (10) of rectangular cross-section, the partition walls (31,32) of the roof member (30) are aligned symmetrically and parallel to the vertical central plane of the switchgear cabinet (10), running from the front side to the rear side of the switchgear cabinet (10), and extend from the rear side of the cooling appliance housing (20) to the front side of the switchgear cabinet (10).

4. Cooling appliance according to one of claims 1 to 3,
**characterised in that**
the roof member (30) is connected via spacing members to the upper side of switchgear cabinet (10) and/or cooling appliance housing (20).

5. Cooling appliance according to one of claims 1 to 4,
**characterised in that**
the roof member (30) has a horizontally aligned cover plate (43) which merges via downwardly sloping transition portions (44) into the edge (45).

6. Cooling appliance according to claim 5,
**characterised in that**
the corners of the roof member (30) are chamfered in the region of the edge (45) and of the transition portions (44).

7. Cooling appliance according to one of claims 1 to 6,
**characterised in that**
the separating plates (31,32) are adapted to the inner cross-section of the roof member (30) and are supported on the upper side of switchgear cabinet (10) and cooling appliance housing (20).

8. Cooling appliance according to one of claims 1 to 7,
**characterised in that**
the vent shaft (24) and the ventilating chambers (22 and 23) are used in a common flow direction to supply air to or take air from the switchgear cabinet (10).

9. Cooling appliance according to one of claims 1 to 7,
**characterised in that**
only the vent shaft (24) or the ventilating chambers (22,23) are used to supply air to or take air from the switchgear cabinet.

## Revendications

1. Appareil réfrigérant destiné à être monté sur la paroi arrière, la paroi latérale ou la porte d'une armoire de distribution et qui par l'intermédiaire d'une ouverture d'admission et d'une ouverture d'évacuation d'un circuit intérieur peut être mis en communication avec ce dernier,
caractérisé
en ce que le boîtier (20) de l'appareil réfrigérant présente, outre une cheminée de ventilation centrale ouverte en haut (24), latéralement de celle-ci des chambres verticales, ouvertes en haut (22, 23) d'un circuit extérieur séparé hermétiquement du circuit intérieur,
en ce que le côté supérieur de l'armoire de distribution (10) et du boîtier (20) de l'appareil réfrigérant (20) est, à distance de ce côté supérieur, couvert par un élément de recouvrement (30), qui de toutes parts fait protubérance par rapport à l'armoire de distribution (10) et par rapport au boîtier (20) de l'appareil réfrigérant et ménage une fente de ventilation périphérique ouverte vers le dessous, et
en ce que l'élément de recouvrement (30) est, au moyen de tôles de séparation (31, 32) subdivisé en chambres (33, 34, 39) qui sont en communication avec la cheminée de ventilation (24) et avec les deux chambres de ventilation (22, 23) du boîtier (20) de l'appareil réfrigérant.

2. Appareil réfrigérant suivant la revendication 1,
caractérisé
en ce que l'élément de recouvrement (30) est doté d'un bord périphérique (45) cintré vers le bas, qui recouvre partiellement la zone des parois latérales de l'armoire de distribution (10) et du boîtier (20) de l'appareil réfrigérant.

3. Appareil réfrigérant suivant la revendication 1 ou la revendication 2,
caractérisé
en ce que dans le cas d'une armoire de distribution (10) à section transversale rectangulaire, les parois de séparation (31, 32) de l'élément de recouvrement (30) sont orientées symétriquement et parallèlement au plan vertical médian rejoignant le côté avant et le côté arrière de l'armoire de distribution (10) et s'étendent depuis le côté arrière du boîtier (20) de l'appareil réfrigérant jusqu'au côté avant de l'armoire de distribution (10).

4. Appareil réfrigérant suivant l'une quelconque des revendications de 1 à 3,
caractérisé
en ce que l'élément de recouvrement (30) est par l'intermédiaire d'éléments d'écartement relié au côté supérieur de l'armoire de distribution (10) et/ou du boîtier de l'appareil réfrigérant (20).

5. Appareil réfrigérant suivant l'une quelconque des revendications de 1 à 4,
caractérisé
en ce que l'élément de recouvrement (30) présente une plaque de couverture (43) orientée horizontalement, qui par l'intermédiaire de sections de transition en pente descendante (44) se raccorde au bord (44).

6. Appareil réfrigérant suivant la revendication 5,
caractérisé en ce que les angles de l'élément de recouvrement (30) sont biseautés dans la zone du bord (45) et des sections de transition (44).

7. Appareil réfrigérant suivant l'une quelconque des revendications de 1 à 6,
caractérisé
en ce que les tôles de séparation (31, 32) sont adaptées à la section transversale intérieure de l'élément de recouvrement (30) et s'appuient sur le côté supérieur de l'armoire de distribution (10) et du boîtier (20) de l'appareil réfrigérant.

8. Appareil réfrigérant suivant l'une quelconque des revendications de 1 à 7,
caractérisé
en ce que la cheminée de ventilation (24) et les chambres de ventilation (22 et 23) sont parcourues suivant un sens de circulation commun pour la ventilation de l'armoire de distribution (10).

9. Appareil réfrigérant suivant l'une quelconque des revendications de 1 à 7,
caractérisé
en ce que seule la cheminée de ventilation (24) ou seules les chambres de ventilation (22, 23) sont utilisées pour la ventilation de l'armoire de distribution (10).
